# EUROPEAN PATENT APPLICATION

(11) **EP 2 020 836 A1**
(43) Date of publication of application: **04.02.2009**
(21) Application number: 08161628.6
(22) Date of filing: 01.08.2008
(51) Int. Cl.: H05K 3/36

(54) **Circuit board connection structure and plasma display apparatus including the same**

(30) Priority: 03.08.2007 KR 20070078164
(71) Applicant: Samsung SDI Co., Ltd., Suwon-si Gyeonggi-do (KR)
(72) Inventor: Kang, Tae-Kyoung c/o Samsung SDI Co., Ltd., Gyeonggi-do (KR)
(74) Representative: Hengelhaupt, Jürgen

(57) **Abstract**

A plasma display apparatus includes a panel assembly, the panel assembly including a plurality of discharge electrodes and a plurality of discharge cells between two substrates, a circuit board having a plurality of circuit terminals and a photoresist layer, the circuit terminals being arranged into a plurality of terminal groups, each terminal group including a plurality of circuit terminals, and the photoresist layer being between the circuit terminals and including at least one dummy groove, a connection member on the circuit terminals and on the photoresist layer, and at least one signal transmitting unit connecting the circuit board to the panel assembly, the signal transmitting unit being attached to the circuit terminals via the connection member.

## Description

### BACKGROUND OF THE INVENTION

### 1. Field of the Invention

Embodiments of the present invention relate to a plasma display apparatus. More particularly, embodiments of the present invention relate to a circuit board connection structure providing an improved electrical connection between the circuit board and a signal transmitting unit, and a plasma display apparatus including the same.

### 2. Description of the Related Art

A plasma display apparatus may refer to a display apparatus displaying numbers, letters, and/or images using a gas discharge. In particular, the gas discharge may be initiated by applying a voltage to a plurality of discharge electrodes between substrates of a plasma display panel (PDP) to trigger emission of ultraviolet (UV) light, so the UV light may excite phosphor layers between the substrates of the PDP to emit visible light. PDPs may be classified into direct current (DC) PDPs and alternating current (AC) PDPs according to a type of driving voltage applied to the discharge electrodes, i.e., according to a discharge type. PDPs may further be classified into facing discharge PDPs and surface discharge PDPs according to an arrangement of the discharge electrodes.

The conventional plasma display apparatus may include a PDP, discharge electrodes in the PDP, e.g., pairs of X and Y sustain discharge electrodes and address electrodes, and a circuit board electrically connected to the PDP via a signal transmitting unit. In particular, in order to transmit electrical signals between the PDP and the circuit board, the signal transmitting unit, e.g., a tape carrier package (TCP), may be electrically connected to terminals of the discharge electrodes of the PDP and to connectors of the circuit board. A connection of the signal transmitting unit to the circuit board via connecters, however, may reduce electrical stability of an electrical contact between the signal transmitting unit and the circuit board. Further, use of the connectors to connect the signal transmitting unit and terminals of the circuit boards may unnecessarily increase number of parts in the plasma display apparatus.

### SUMMARY OF THE INVENTION

Embodiments of the present invention are therefore directed to a circuit board connection structure and a plasma display apparatus, which substantially overcome one or more of the disadvantages of the related art.

It is therefore a feature of an embodiment of the present invention to provide a circuit board connection structure with an improved electrical connection between the circuit board and discharge electrodes of a PDP.

It is another a feature of an embodiment of the present invention to provide a plasma display apparatus with a circuit board connection structure with an improved electrical connection between the circuit board and discharge electrodes of a PDP. At least one of the above and other features and advantages of the present invention may be realized by providing a circuit board connection structure, including a circuit board having a plurality of circuit terminals and a photoresist layer, the circuit terminals being arranged into a plurality of terminal groups, each terminal group including a plurality of circuit terminals, and the photoresist layer being between the circuit terminals and including at least one dummy groove, a connection member on the circuit terminals and on the photoresist layer, and at least one signal transmitting unit attached to the circuit terminals via the connection member.

The photoresist layer may include a first photoresist layer and a second photoresist layer, the first photoresist layer being between circuit terminals in each of the plurality of terminal groups and the second photoresist layer being between terminal groups. A thickness of the first photoresist layer may be greater than a thickness of the circuit terminals. The connection member may overlap the circuit terminals, the first photoresist layer, and the second photoresist layer. The dummy groove may be between the first and second photoresist layers. The circuit board may include an effective region and a non-effective region, the signal transmitting unit being positioned only in the effective region, and the dummy groove being positioned in the non-effective region. The dummy groove may have a depth of about 0.03 mm to about 1 mm. The circuit board connection structure may further include circuit electrodes in the dummy groove, the circuit electrodes not being grounded. The connection member may be an anisotropic conductive film (ACF). The ACF may include an adhesive layer and particles dispersed in the adhesive layer, each of the particles being a conductive particle coated with an insulating film. Upper and lower surfaces of the adhesive layer may contact the circuit terminals and terminals of the signal transmitting unit, respectively, the insulating film of the particles being configured to break upon pressing the connection member to provide electrical connection between the circuit terminals and the terminals of the signal transmitting unit via the conductive particles. The signal transmitting unit may include a flexible film, driving ICs in the flexible film, and leads electrically connected to the driving ICs and to the circuit board.

At least one of the above and other features and advantages of the present invention may be also realized by providing a plasma display apparatus, including a panel assembly, the panel assembly including a plurality of discharge electrodes and a plurality of discharge cells between two substrates, a circuit board having a plurality of circuit terminals and a photoresist layer, the circuit terminals being arranged into a plurality of terminal groups, each terminal group including a plurality of circuit terminals, and the photoresist layer being between the circuit terminals and including at least one dummy groove, a connection member on the circuit terminals and on the photoresist layer, and at least one signal transmitting unit connecting the circuit board to the panel assembly, the signal transmitting unit being attached to the circuit terminals via the connection member.

The signal transmitting unit may include a flexible film, driving ICs in the flexible film, and leads electrically connected to the driving ICs, the leads being electrically connected to the discharge electrodes of the panel assembly and to circuit electrodes of the circuit board. The photoresist layer may include a first photoresist layer and a second photoresist layer, the first photoresist layer being between adjacent circuit terminals in each of the plurality of terminal groups and the second photoresist layer being between adjacent terminal groups. The second photoresist layer may be an outermost layer with respect to each terminal group. The dummy groove may be between each terminal group and the second photoresist layer. The circuit board may include an effective region and a non-effective region, the signal transmitting unit being positioned only in the effective region, and the dummy groove being positioned in the non-effective region. The circuit board, the connection member, and the signal transmitting unit may define a signal connection unit, the signal connection unit being separate from the panel assembly. The signal transmitting unit may be on the circuit board, the connection member being between the signal transmitting unit and the circuit board.

### BRIEF DESCRIPTION OF THE DRAWINGS

The above and other features and advantages of the present invention will become more apparent to those of ordinary skill in the art by describing in detail exemplary embodiments thereof with reference to the attached drawings, in which:
FIG. 1 illustrates a partial, exploded perspective view of a plasma display apparatus according to an embodiment of the present invention;
FIG. 2 illustrates a schematic plan view of a circuit board connection structure according to an embodiment of the present invention;
FIG. 3 illustrates a magnified plan view of the circuit board connection structure of FIG. 2; and
FIG. 4 illustrates a magnified cross-sectional view along line IV-IV of FIG. 3.

### DETAILED DESCRIPTION OF THE INVENTION

Exemplary embodiments of the present invention will now be described more fully hereinafter with reference to the accompanying drawings, in which exemplary embodiments of the invention are illustrated. Aspects of the invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of elements and regions may be exaggerated for clarity of illustration. It will also be understood that when an element is referred to as being "on" another element or substrate, it can be directly on the other element or substrate, or intervening elements may also be present. Further, it will be understood that the term "on" can indicate solely a vertical arrangement of one element with respect to another element, and may not indicate a vertical orientation, e.g., a horizontal orientation. In addition, it will also be understood that when an element is referred to as being "between" two elements, it can be the only element between the two elements, or one or more intervening elements may also be present. Like reference numerals refer to like elements throughout.

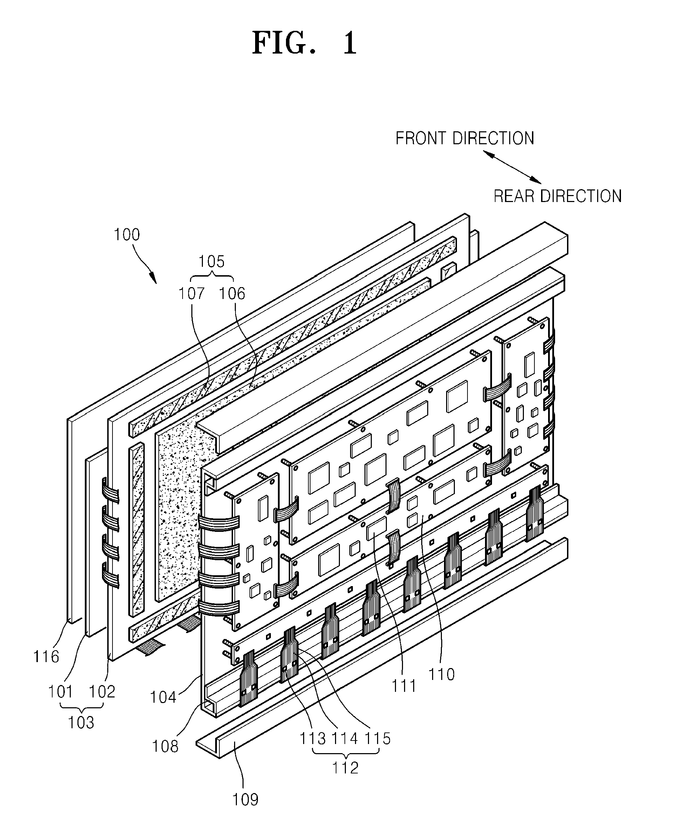

FIG. 1 illustrates a partial, exploded perspective view of a plasma display apparatus 100 according to an embodiment of the present invention. Referring to FIG. 1, the plasma display apparatus 100 may include a panel assembly 103 and a chassis base 104 attached to the panel assembly 103.

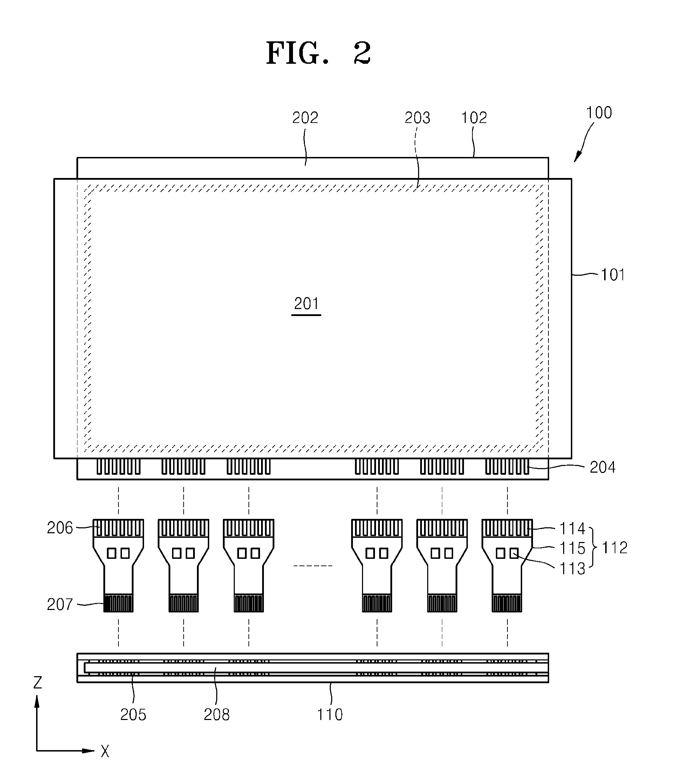

The panel assembly 103 may include a first substrate 101 and a second substrate 102 disposed in parallel and spaced apart from each other. Each one of the first and second substrates 101 and 102 may be a soda lime glass substrate, a semitransparent substrate, a reflective substrate, and/or a colored substrate. A closed discharge space may be formed between the first and second substrates 101 and 102 by coating a frit glass 203, as illustrated in FIG. 2, along inner boundaries of the first and second substrates 101 and 102. In particular, the closed discharge space between the first and second substrates 101 and 102, i.e., a display region 201, may be defined by an overlap between the first and second substrates 101 and 102 facing each other, as illustrated in FIG. 2. The display region 201 may include functional elements, e.g., discharge electrodes and discharge cells, and may provide display functions, i.e., where an image may be displayed during a discharge.

Portions of the first and/or second substrates 101 and 102 not in the display region 201, e.g., portions of the second substrate 102 extending beyond the first substrate 101, may be referred to as a non-display region 202, and may include electrode terminals 204 of the discharge electrodes, e.g., electrode terminals of sustain electrodes and/or address electrodes. The non-display region 202 may be a peripheral area in communication with at least one edge of the display region 201 to expose the electrode terminals 204. As illustrated in FIG. 2, the frit glass 203 may be coated along a boundary between the display region 201 and the non-display region 202.

Although not shown, if the plasma display apparatus 100 includes a three-electrode surface discharge type PDP, the PDP may include the discharge electrodes, e.g., sustain electrodes and/or address electrodes, barrier ribs, and at least one dielectric layer between the first and second substrates 101 and 102 of the panel assembly 103. The sustain electrodes may include pairs of X and Y electrodes on an inner surface of the first substrate 101. The sustain electrodes may be buried by a first dielectric layer, and a protective film layer, e.g., a MgO layer, for increasing emission of secondary electrons may be formed on a surface of the first dielectric layer. The address electrodes may be patterned on an inner surface of the second substrate 102 in a direction crossing a direction of the sustain electrodes, and may be buried by a second dielectric layer. The barrier ribs may be formed between the first and second substrates 101 and 102 to define a plurality of discharge cells, and a discharge gas, e.g., neon (Ne), xenon (Xe), helium (He), or combinations thereof, may be injected into the discharge cells. Phosphor layers, e.g., red, green, and/or blue phosphor layers, may be formed in the discharge cells, e.g., on sidewalls of the barrier ribs.

The sustain electrode pairs may be grouped into a plurality of groups, and the address electrodes may be grouped into a plurality of groups.

When an electrical signal is applied to the Y electrodes and the address electrodes, address discharge may be generated in predetermined discharge cells to select discharge cells to be operated. When an electrical signal is alternately applied to the X and Y sustain electrodes, sustain discharge may be generated in the selected discharge cells. The generated sustain discharge may generate UV light to excite the phosphor layers in the discharge cells to emit colored visible light for displaying colored images.

The chassis base 104 of the plasma display apparatus 100 may be coupled to a rear surface of the panel assembly 103. For example, as illustrated in FIG. 1, a front surface of the chassis base 104 may be attached to a rear surface of the second substrate 102 via an adhesion means 105. The adhesion means 105 may include a thermal conductive sheet 106 attached to a center of the rear surface of the second substrate 102 to transmit heat generated in the panel assembly 103 to the chassis base 104, and a dual-sided tape 107 attached to edges of the rear surface of the second substrate 102, e.g., along a perimeter of the rear surface of the second substrate 102, where the thermal conductive sheet 106 is not attached.

The chassis base 104 may include a chassis reinforcing member 108 and cover plates 109, as illustrated in FIG. 1. The chassis reinforcing member 108 may be on a rear surface of the chassis base 104, e.g., along upper and lower portions of the rear surface of the chassis base 104, to reinforce strength of the chassis base 104. The cover plates 109 may cover the upper and lower edges of the chassis base 104, e.g., may be installed respectively on upper and lower portions of the rear surface of the chassis base 104 along the chassis reinforcing members 108.

A plurality of circuit boards 110 may be mounted on a rear surface of the chassis base 104, as illustrated in FIG. 1, and may include a plurality of circuit devices 111. As further illustrated in FIG. 1, the circuit boards 110 may be electrically connected to the panel assembly 103 via signal transmitting units 112. The signal transmitting units 112 may extend between the circuit boards 110 and the panel assembly 103 over edges of the plasma display apparatus 100. For example, as illustrated in FIG. 1, the signal transmitting units 112 may be interposed between the chassis reinforcing member 108 and the cover plate 109, so a thermal grease (not shown) may be interposed between driving ICs of the signal transmitting units 112 and the chassis reinforcing member 108, and a silicon sheet (not shown) may be interposed between the driving ICs of the signal transmitting units 112 and the cover plate 109. The signal transmitting unit 112 may have any suitable shape.

More specifically, each signal transmitting unit 112 may include a first end connected to circuit terminals 205 of a circuit board 110 and a second end connected to the electrode terminals 204 in the non-display region 202 of the panel assembly 103, as illustrated in FIGS. 1-2, to transmit electrical signals between the circuit boards 110 and the panel assembly 103. In particular, as illustrated in FIG. 2, each signal transmitting unit 112 may include a plurality of driving integrated circuits (ICs) 113, a lead 114 patterned to be electrically connected to the driving ICs 113, and a flexible film 115 burying the lead 114. As further illustrated in FIG. 2, the lead 114 may include first terminals 207 at a first end and second terminals 206 at a second end opposite the first end. Accordingly, the flexible film 115 may entirely cover the lead 114 except the first and second ends thereof to expose the first and second terminals 207 and 206, respectively.

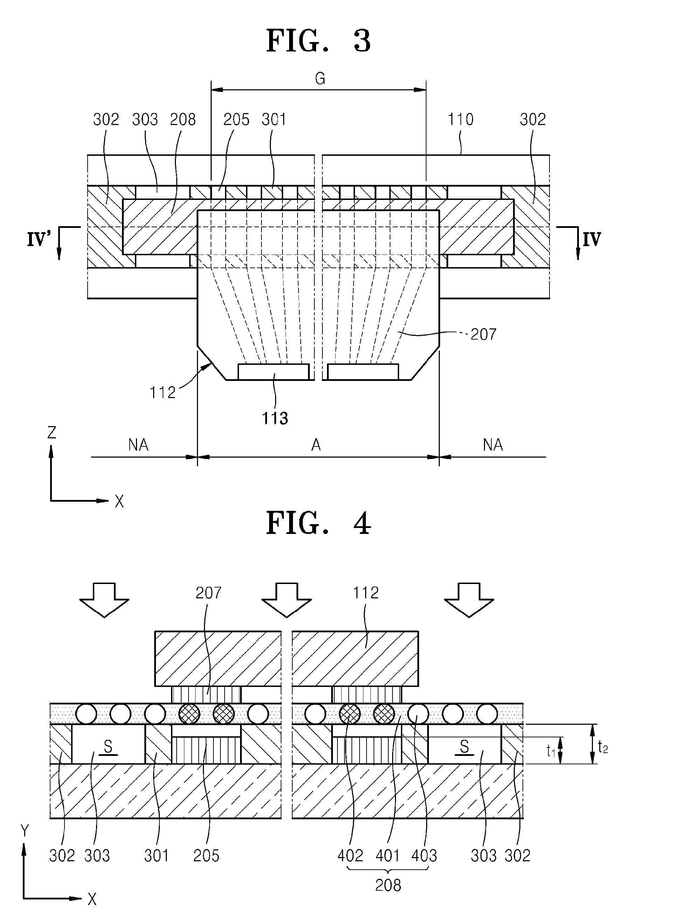

The first terminals 207 of the signal transmitting unit 112 may be connected to the circuit terminals 205 of the circuit boards 110 and the second terminals 206 of the signal transmitting unit 112 may be connected to the exposed electrode terminals 204 in the panel assembly 103. In order to facilitate the electrical connection between the first terminals 207 of the signal transmitting unit 112 and the circuit terminals 205 of the circuit board 110, a connection member 208 may be interposed between the first terminals 207 and the circuit terminals 205, and a photoresist layer with a dummy groove may be formed between the circuit terminals 205 of the circuit board 110, as will be explained in more detail below with reference to FIGS. 3-4.

The electrode terminals 204 may be terminals of sustain electrodes or address electrodes. For example, the electrodes terminals 204 may extend from edges of the sustain electrode along a substantially same direction as the sustain electrodes. The electrode terminals 204 may be arranged, e.g., in a stripe pattern, in at least one non-display region 202, as illustrated in FIG. 2. The electrode terminals 204 may be arranged into a plurality of groups spaced apart from each other, and each group may include a plurality of electrode terminals 204, as illustrated in FIG. 2. A group of electrode terminals 204 may be separately connected to a single signal transmitting unit 112, so a large size of the plasma display apparatus 100 may require a plurality of signal transmitting units 112 connected to a plurality of electrode terminals 204 arranged into a plurality of groups.

The plasma display apparatus 100 may further include a filter assembly 116 on a front surface of the panel assembly 103, as illustrated in FIG. 1. The filter assembly 116 may include a plurality of films to block electromagnetic waves and/or neon light generated in the panel assembly 103 during gas discharge and/or to block reflection of external light. For example, the filter assembly 116 may include a reflection preventive film, e.g., a film processed with an anti-reflection treatment to reduce external light reflection from the panel assembly 103, an electromagnetic wave shielding filter to effectively block the electromagnetic waves generated during the operation of the panel assembly 103, and/or a selective wavelength absorption film to block neon light having a wavelength region of about 590 nm when an image is displayed. The filter assembly 116 may include additional functional films.

FIG. 3 illustrates a magnified plan view of a connection between the circuit terminals 205 of the circuit board 110 and the first terminals 207 of the signal transmitting unit 112 of FIG. 2, and FIG. 4 illustrates a magnified cross-sectional view along line IV-IV' of FIG. 3.

Referring to FIGS. 3-4, the circuit terminals 205 of the circuit board 110 may extend from the circuit board 110 along a first direction, e.g., along the z-axis, toward the electrode terminals 204, and may be spaced apart from each other along a second direction, e.g., along the x-axis. The circuit terminals 205 may be arranged into a plurality of circuit terminal groups G, so each circuit terminal group G may include a plurality of circuit terminals 205. The circuit terminal groups G may be spaced apart from each other. The arrangement of the circuit terminal groups G and the circuit terminals 205 in each circuit terminal group G may correspond to an arrangement of the first terminals 207 of the signal transmitting units 112. For example, one signal transmitting unit 112 may correspond in size and shape to one circuit terminal group G of circuit terminals 205.

As further illustrated in FIGS. 3-4, first and second photoresist layers 301 and 302 may be selectively formed on the circuit board 110 in regions not including the circuit terminals 205. In particular, the first photoresist layer 301 may extend along the first direction, and may be positioned between circuit terminals 205. For example, the first photoresist layer 301 may be discontinuous, i.e., include a plurality of discrete portions not connected to each other, and may be formed between adjacent circuit terminals 205 of each circuit terminal group G to prevent or substantially minimize contact between adjacent circuit terminals 205. As such, portions of the photoresist layer 301 and the circuit terminals 205 in each circuit terminal group G may form an alternating pattern, i.e., a portion of the photoresist layer 301 may be between two adjacent circuit terminals 205. A thickness t₂ of the first photoresist layer 301, i.e., a distance as measured along the y-axis, may be greater than a thickness t₁ of the circuit elements 205, so the alternating pattern of the photoresist layer 301 and the circuit terminals 205 in each circuit terminal group G may have a non uniform thickness, i.e., a level difference between the photoresist layer 301 and the circuit terminals 205. The first photoresist layer 301 may be formed after patterning the circuit terminals 205, e.g., by depositing a photoresist material on the circuit board 110 between patterned circuit terminals 205. Accordingly, the thickness t₂ of the first photoresist layer 301 may be easily adjusted to have a larger numerical value than the thickness t₁ of the circuit elements 205.

The second photoresist layer 302 may extend along the first direction, and may be positioned in outermost regions with respect to each of the circuit terminal groups G. For example, the second photoresist layer 302 may be positioned between adjacent circuit terminal groups G of circuit terminals 205. The second photoresist layer 302 may have a substantially same thickness as the first photoresist layer 301, and may be formed simultaneously with the first photoresist layer 301. Widths of the first and second photoresist layers 301 and 302 along the z-axis may be determined according to design requirements and specification, e.g., the widths of the first and second photoresist layers 301 and 302 may substantially equal lengths of the circuit terminals 205 along the z-axis.

The connection member 208 may be disposed between the first terminals 207 of the signal transmitting unit 112 and the circuit terminals 205 of the circuit board 110. In particular, the connection member 208 may have a linear structure, e.g., a stripe shape, and may be disposed to overlap each patterned circuit terminal group G, the first photoresist layer 301 being between the circuit terminals 205 and the second photoresist layer 302 in an outermost region of each of the circuit terminal groups G. The connection member 208 may be pressed by the first terminals 207 of the signal transmitting unit 112 onto the circuit board 110 to cover the circuit terminals 205 of the circuit board 110. The first terminals 207 of the signal transmitting unit 112 may be positioned on the connection member 208, such that the first terminals 207 may be aligned with the circuit terminals 205 with the connection member 208 therebetween. The connection member 208 may be formed of any suitable material capable of electrically connecting the second terminals 207 of the signal transmitting unit 112 to the circuit terminals 205 of the circuit board 110. For example, the connection member 208 may be an anisotropic conductive film (ACF).

More specifically, if the connection member 208 is an ACF, the connection member 208 may include a plurality of particles 403, e.g., ball-shaped members, dispersed in an adhesive layer 401, e.g., a polymer resin. Each of the particles 403 may include a conductive particle 402 coated with an insulating film. The connection member 208 may be disposed on the circuit board 110, so the particles 403 may be uniformly dispersed in the adhesive layer 401 along the connection member 208. When the first terminals 207 of the signal transmitting unit 112 are pressed onto the circuit board 110 with the connection member 208 therebetween, as illustrated by the arrows in FIG. 4, insulating films coating the conductive particles 402 directly between the first terminals 207 of the signal transmitting unit 112 and the circuit terminals 205 of the circuit board 110 may brake, i.e., in regions where the first terminals 207 and the circuit terminals 205 completely overlap. Accordingly, the conductive particles 402 may be in contact with the first terminals 207 and the circuit terminals 205, i.e., only the conductive particles 402 may remain between the first terminals 207 and the circuit terminals 205, to electrically connect therebetween. Regions not overlapping both the first terminals 207 and the circuit terminals 205 may include particles 403 with unbroken insulating films, so regions between adjacent circuit terminals 205, e.g., regions overlapping the first and/or second photoresisit layers 301 and 302, may include an insulating material to prevent or substantially minimize electrical contact between adjacent circuit terminals 205. Accordingly, in order to connect the first terminals 207 of the signal transmitting unit 112 with the circuit terminals 205, the signal transmitting unit 112 may be pressed in a direction indicated by the arrows, e.g., along the y-axis, to exert force and/or heat on the connection member 208, i.e., an ACF, between the circuit terminals 205 and the first terminals 207. Portions of the connection member 208 between the circuit terminals 205 and the first terminals 207 of the signal transmitting unit 112 may be deformed by the exerted force, e.g., bent along the arrows into a space directly above the circuit terminals 205, and the insulating film on surfaces of the particles 403 may be broken to expose the conductive particles 402. Accordingly, the circuit terminals 205 and the second terminals 207 may be electrically connected by the conductive particles 402, and the particles 403, i.e., particles 403 with unbroken insulting films, may be dispersed between adjacent connection points of the circuit terminals 205 and the first terminals 207.

Also, at least one dummy groove 303 may be formed in the second photoresist layer 302. More specifically, a predetermined portion of the second layer 302 on the circuit board 110 may not be formed to define the dummy groove 303. The dummy groove 303 may be formed on the circuit board 110, e.g., directly on the circuit board 110, and may be positioned between a side surface of the photoresist layer 302 and a side surface of an adjacent first photoresist layer 301. In other words, circuit terminal groups G of circuit terminals 205 may be disposed on the circuit board 110, so one signal transmitting unit 112 may correspond to each of the circuit terminal groups G and one dummy groove 303 may be formed between two adjacent circuit terminal groups G.

A depth of the dummy groove 303 may substantially equal the thicknesses t₂ of the first and second photoresist layers 301 and 302, e.g., about 0.03 mm to about 1 mm, and a width of the dummy groove 303 along the x-axis may substantially equal the widths of the circuit terminals 205. The dummy groove 303 may have a predetermined space S. It is noted that other configurations of the dummy groove 303, e.g., a plurality of dummy grooves 303 having a substantially same pattern as a region including the circuit terminals 205 may be formed at each outermost region of each group G.

Formation of the dummy groove 303 may be advantageous in improving connection uniformity between the first terminals 207 of the signal transmitting unit 112 and the circuit terminals 205 of the circuit board 110. More specifically, the first photoresist layer 301 having the thickness t₂ may be positioned between the circuit terminals 205 having the thickness t₁ to form a first alternating pattern with a predetermined thickness difference as described previously. Use of a second photoresist layer 302 having substantially no thickness difference, i.e., a substantially uniform thickness without the dummy groove 303, may cause a non-uniform contact between the second terminals 207 and the circuit terminals 205 via the connection member 208 because of the different thickness differences, i.e., a structure difference between the first alternating pattern having a thickness difference and a second photoresist layer 302 having a substantially uniform thickness. As such, formation of the dummy groove 303 adjacent to the second photoresist layer 302 may facilitate formation of a second alternating pattern having a substantially same thickness difference as the first alternating pattern. It is noted that a thickness difference of an alternating pattern refers to a difference of thickness between elements of the alternating pattern, e.g., a difference between thickness t₂ and thickness t₁ of an alternating pattern including the circuit terminals 205 and the first photoresist layer 301.

For example, the dummy groove 303 may have a substantially same height and width as height and width, respectively, of a region including a circuit terminal 205. The region including one circuit terminal 205 may refer to a region having a width as measured along the x-axis between facing sidewalls of adjacent portions of the first photoresist layer 301 and having a height as measured along the y-axis between an upper surface of the circuit board 110 and a lower surface of an un-pressed connection member 208. A depth of the dummy groove 303 may be about 0.03 mm to about 1 mm in order to maintain a uniform thickness difference when the connection member 208 is pressed between the circuit terminals 205 and the second terminals 207.

The circuit board 110 may be divided into an effective region A including the signal transmitting units 112 and a non-effective region NA including no signal transmitting units 112. Accordingly, in order to apply a uniform pressing force to the signal transmitting units 112, the dummy grooves 303 may be formed in the non-effective region NA. In other words, the signal transmitting units 112 may not overlap with the dummy grooves 303.

Circuit electrodes (not shown) may be formed on the circuit board 110 in the dummy grooves 303. If the circuit electrodes are formed, the circuit electrodes may not be grounded to prevent or substantially minimize shorting thereof due to presence of foreign materials, e.g., dust on an upper surface of the connection member 208.

The plasma display apparatus 100 according to embodiments of the present invention may be advantageous in providing the circuit board 110 with an alternating pattern of circuit terminals 205 and the first photoresist layer 301 having different thicknesses and the second photoresist layer 302 in outermost regions of each group of the circuit terminals 205. At least one dummy groove 303 having a predetermined space S may be formed in portions of regions of the second photoresist layer 302 to provide a pattern with different thicknesses to correspond to the alternating pattern of the circuit terminals 205 and the first photoresist layer 301. Accordingly, the connection member 208, e.g., an ACF, may be disposed across the patterned circuit terminals 205, the first photoresist layer 301, and the second photoresist layer 302 with the dummy groove 303, so the first terminals 207 may be aligned with the circuit terminals 205 with the connection member 208 therebetween. The signal transmitting units 112 may be pressed to the circuit board 110 with the connection member 208 therebetween to provide connection via application of predetermined heat and pressure. It is noted that the circuit board 110, the connection member 208, and the signal transmitting unit 112 may define a signal connection unit separated from the panel assembly 103, i.e., the panel assembly 103 may be a discrete unit with respect to the signal connection unit.

At this point, a thickness difference between upper surfaces of the first photoresist layer 301 and the circuit terminals 205 may vary, e.g., may be alternately formed, in a substantially same way as a thickness difference between the dummy grooves 303 and the second photoresist layer 302. Accordingly, the thickness differences may be substantially uniform in both effective regions A and non-effective regions NA to provide a substantially uniform attachment between the second terminals 207 and the circuit terminals 205.

As described above, a circuit board connection structure and a plasma display apparatus including the same according to embodiments of the present invention may be advantageous in providing an improved electrical connection between the circuit board and a PDP of the plasma display apparatus. In particular, when terminals of a signal transmitting unit are pressed to circuit terminals of the circuit board via a connection member, a level difference between the circuit terminals and a first photoresist layer formed between the circuit terminals may be uniformly maintained with respect to a level difference between a second photoresist layer in outermost regions of the circuit terminal groups G and dummy grooves formed therein. Thus, a uniform pressing force may be transmitted to the connection member between the circuit terminals and the signal transmitting unit, thereby facilitating an electrical contact between the circuit terminals and the signal transmitting unit, i.e., between the circuit board and the PDP.

## Claims

1. A circuit board connection structure, comprising:
a circuit board having a plurality of circuit terminals and a photoresist layer, the circuit terminals being arranged into a plurality of terminal groups, each terminal group including a plurality of circuit terminals, and the photoresist layer being between the circuit terminals and including at least one dummy groove;
a connection member on the circuit terminals and on the photoresist layer; and
at least one signal transmitting unit attached to the circuit terminals via the connection member.

2. The circuit board connection structure as claimed in claim 1, wherein the photoresist layer includes a first photoresist layer and a second photoresist layer, the first photoresist layer being between circuit terminals in each of the plurality of terminal groups and the second photoresist layer being between terminal groups.

3. The circuit board connection structure as claimed in claim 2, wherein a thickness of the first photoresist layer is greater than a thickness of the circuit terminals.

4. The circuit board connection structure as claimed in claim 2 or 3, wherein the connection member overlaps the circuit terminals, the first photoresist layer, and the second photoresist layer.

5. The circuit board connection structure as claimed in one of claims 2 to 4, wherein the dummy groove is between the first and second photoresist layers.

6. The circuit board connection structure as claimed in one of the preceding claims, wherein the circuit board includes an effective region and a non-effective region, the signal transmitting unit being positioned only in the effective region, and the dummy groove being positioned in the non-effective region.

7. The circuit board connection structure as claimed in one of the preceding claims, wherein the dummy groove has a depth of about 0.03 mm to about 1 mm.

8. The circuit board connection structure as claimed in one of the preceding claims, further comprising circuit electrodes in the dummy groove, the circuit electrodes not being grounded.

9. The circuit board connection structure as claimed in one of the preceding claims, wherein the connection member is an anisotropic conductive film (ACF).

10. The circuit board connection structure as claimed in claim 9, wherein the ACF includes an adhesive layer and particles dispersed in the adhesive layer, each of the particles being a conductive particle coated with an insulating film.

11. The circuit board connection structure as claimed in claim 10, wherein upper and lower surfaces of the adhesive layer contact the circuit terminals and terminals of the signal transmitting unit, respectively, the insulating film of the particles being configured to break upon pressing the connection member to provide electrical connection between the circuit terminals and the terminals of the signal transmitting unit via the conductive particles.

12. The circuit board connection structure as claimed in one of the preceding claims, wherein the signal transmitting unit includes a flexible film, driving ICs in the flexible film, and leads electrically connected to the driving ICs and to the circuit board.

13. A plasma display apparatus, comprising:
a panel assembly, the panel assembly including a plurality of discharge electrodes and a plurality of discharge cells between two substrates; and
the circuit board connection structure as claimed in one of the preceding claims,
wherein the at least one signal transmitting unit connects the circuit board to the panel assembly.

14. The plasma display apparatus as claimed in claim 13 and 12, wherein the leads are electrically connected to the discharge electrodes of the panel assembly and to circuit electrodes of the circuit board.

15. The plasma display apparatus as claimed in claim 13 and 2, wherein the second photoresist layer is an outermost layer with respect to each terminal group.

16. The plasma display apparatus as claimed in one of claims 13 to 15, wherein the circuit board, the connection member, and the signal transmitting unit define a signal connection unit, the signal connection unit being separate from the panel assembly.

17. The plasma display apparatus as claimed in one of claims 13 to 16, wherein the signal transmitting unit is on the circuit board, the connection member being between the signal transmitting unit and the circuit board.
